# EUROPEAN PATENT APPLICATION

(11) **EP 4 645 382 A2**
(43) Date of publication of application: **05.11.2025**
(21) Application number: 25167850.4
(22) Date of filing: 01.04.2025
(51) Int. Cl.: H01L 23/15, H01L 23/00

(54) **GLASS WAFERS INTEGRATED WITH SEMICONDUCTOR STRUCTURES WITH OPTICAL INTERCONNECTS**

(30) Priority: 02.05.2024 US 202418652890
(71) Applicant: INTEL Corporation, Santa Clara, CA 95054 (US)
(72) Inventor: SHARMA, Abhishek Anil, Portland, OR 97229 (US); GOMES, Wilfred, Portland, OR 97229 (US)
(74) Representative: HGF

(57) **Abstract**

Disclosed herein are microelectronic assemblies having glass structures integrated with semiconductor structures with optical interconnects. An example microelectronic assembly includes a glass structure having a first face and an opposite second face, and a semiconductor structure having a first face and an opposite second face. The first face of the glass structure is further away from the semiconductor structure than the second face of the glass structure, the second face of the glass structure is bonded with the first face of the semiconductor structure, and the semiconductor structure includes an opening extending between the first face of the semiconductor structure and the second face of the semiconductor structure. The microelectronic assembly further includes an optical interconnect in the opening, where the optical interconnect includes a glass material, a material that either includes aluminum and oxygen or includes aluminum and nitrogen, or a material having a hexagonal crystal structure.

## Description

### Background

Glass wafers serve several important functions in the context of optical/photonic devices. For example, glass wafers are typically highly transparent to light across a wide range of wavelengths, allowing optical signals to pass through with minimal absorption or scattering. This transparency is crucial for efficient transmission of optical signals in optical interconnects. In another example, glass wafers can provide mechanical support and structural stability to optical/photonic components and can help maintain the precise alignment of optical elements (e.g., of photonic integrated circuits (PICs)), ensuring the proper functioning of devices.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1A-1C illustrate cross-sectional side views during manufacturing of a microelectronic assembly that includes a glass wafer integrated with a semiconductor structure with optical interconnects, in accordance with some embodiments.
FIGS. 2A-2C illustrate cross-sectional side views during manufacturing of a microelectronic assembly that includes a glass wafer integrated with a semiconductor structure with optical interconnects, in accordance with other embodiments.
FIGS. 3A-3D illustrate cross-sectional side views of microelectronic assemblies that include a glass wafer integrated with stacks of semiconductor structures with optical interconnects, in accordance with various embodiments.
FIG. 4 illustrates top views of a wafer and dies that may be included in microelectronic assemblies having glass wafers integrated with semiconductor structures with optical interconnects, in accordance with various embodiments.
FIG. 5 is a side, cross-sectional view of an integrated circuit (IC) device that may be included in microelectronic assemblies having glass wafers integrated with semiconductor structures with optical interconnects, in accordance with various embodiments.
FIG. 6 is a side, cross-sectional view of an IC package that may include one or more microelectronic assemblies having glass wafers integrated with semiconductor structures with optical interconnects, in accordance with various embodiments.
FIG. 7 illustrates a cross-sectional side view of an IC device assembly that may include one or more microelectronic assemblies having glass wafers integrated with semiconductor structures with optical interconnects, in accordance with various embodiments.
FIG. 8 is a block diagram of an example computing device that may include one or more microelectronic assemblies having glass wafers integrated with semiconductor structures with optical interconnects, in accordance with various embodiments.
FIG. 9 is a block diagram of an example processing device that may include one or more microelectronic assemblies having glass wafers integrated with semiconductor structures with optical interconnects, in accordance with various embodiments.

### Detailed Description

Disclosed herein are microelectronic assemblies having glass wafers (or, more generally, glass structures) integrated with semiconductor structures with optical interconnects, and related devices and techniques. In one aspect, an example microelectronic assembly includes a glass structure having a first face and an opposite second face, and a semiconductor structure having a first face and an opposite second face. The first face of the glass structure is further away from the semiconductor structure than the second face of the glass structure, the second face of the glass structure is bonded with the first face of the semiconductor structure, and the semiconductor structure includes an opening extending between the first face of the semiconductor structure and the second face of the semiconductor structure. The microelectronic assembly further includes an optical interconnect in the opening, where the optical interconnect includes a glass material, a material that either includes aluminum and oxygen or includes aluminum and nitrogen, or a material having a hexagonal crystal structure.

Embodiments of the present disclosure are present on recognition that semiconductor materials such as silicon are the dominant materials in semiconductor manufacturing, especially for electronic ICs. By bonding a glass wafer with a semiconductor wafer, it becomes possible to integrate PICs and other photonic components with traditional electronic ICs in a single microelectronic assembly, e.g., on the same substrate. This integration is essential for applications like silicon photonics, where optical interconnects are used alongside electronic circuits.

In the following detailed description, various aspects of the illustrative implementations may be described using terms commonly employed by those skilled in the art to convey the substance of their work to others skilled in the art. For example, the terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 20%, e.g., within +/- 5% or within +/-2% of a target value based on the context of a particular value as described herein or as known in the art. The term "circuit" or "IC" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

Although certain elements may be referred to in the singular herein, such elements may include multiple sub-elements. For example, "an insulator material" may include one or more insulator materials. The term "insulating" and variations thereof (e.g., "insulative" or "insulator") means "electrically insulating," the term "conducting" and variations thereof (e.g., "conductive" or "conductor") means "electrically conducting," unless otherwise specified. For example, the term "insulator material" may refer to solid materials (and/or liquid materials that solidify after processing as described herein) that are substantially electrically non-conducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. With reference to optical signals and/or devices, components and elements that operate on or using optical signals, the term "conducting/conductive" can also mean "optically conducting/conductive."

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

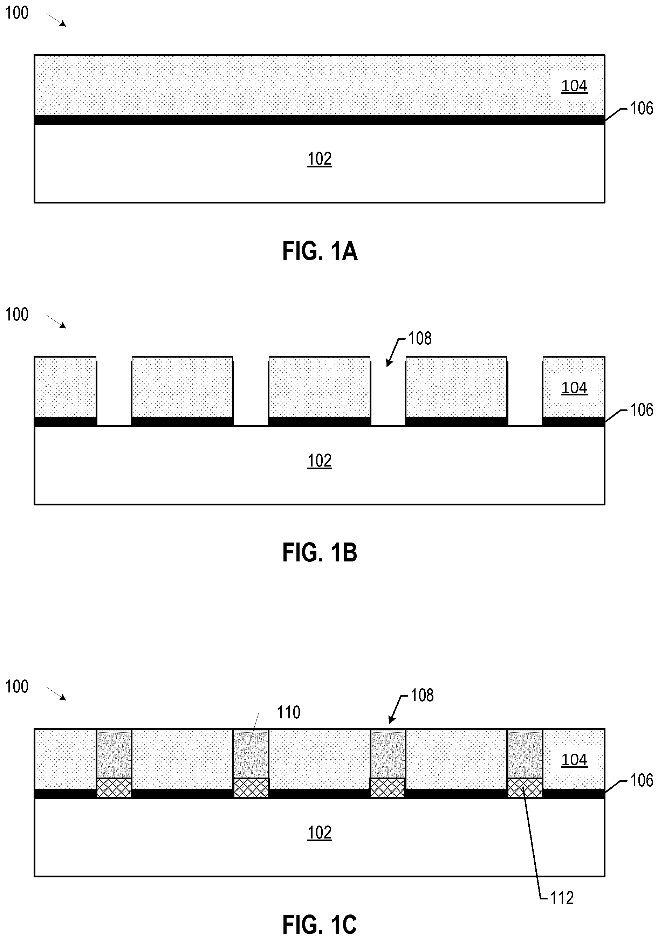

Any of the features discussed with reference to any of accompanying drawings herein may be combined with any other features to form microelectronic assemblies having glass wafers integrated with semiconductor structures with optical interconnects, as appropriate. A number of elements of the drawings are shared with others of the drawings; for ease of discussion, a description of these elements is not repeated, and these elements may take the form of any of the embodiments disclosed herein. If multiple instances of certain elements are illustrated, then, in some cases, to not clutter the drawings only some of these elements may be labeled with a reference sign and other ones of these elements are not labeled (e.g., although FIG. 1B illustrates multiple openings 108, only one is labeled with a reference sign). However, in other cases, for ease of explanation, different instances of a given element in a single drawing may be referred to with numbers 1, 2, and so on, after a dash.

The drawings are not necessarily to scale. In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of microelectronic assemblies having glass wafers integrated with semiconductor structures with optical interconnects as described herein.

Various microelectronic assemblies having glass wafers integrated with semiconductor structures with optical interconnects as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

FIGS. 1A-1C illustrate cross-sectional side views during manufacturing of a microelectronic assembly 100 that includes a glass wafer integrated with a semiconductor structure with optical interconnects, in accordance with some embodiments.

As shown in FIG. 1A, manufacturing of a microelectronic assembly 100 may begin with bonding a glass wafer 102 with a semiconductor structure 104. As a result of the bonding, a bonding interface 106 may be present between the glass wafer 102 and the semiconductor structure 104.

As used herein, the term "glass wafer" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass wafer 102 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass wafer 102 may be an amorphous solid glass layer. In some embodiments, the glass wafer 102 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass wafer 102 may include a material, e.g., any of the materials described above, with a weight percentage of silicon being at least about 0.5%, e.g., between about 0.5% and 50%, between about 1% and 48%, or at least about 23%. For example, if the glass wafer 102 is fused silica, the weight percentage of silicon may be about 47%. In some embodiments, the glass wafer 102 may include a material having at least 23% silicon and/or at least 26% oxygen by weight, and, in some further embodiments, the glass wafer 102 may further include at least 5% aluminum by weight. In some embodiments, the glass wafer 102 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass wafer 102 may be a layer of glass that does not include an organic adhesive or an organic material. The glass wafer 102 may be distinguished from, for example, the "prepreg" or "RF4" core of a printed circuit board (PCB) substrate which typically includes glass fibers embedded in a resinous organic material such as an epoxy. In such traditional cores/substrates including glass fibers and epoxy, the diameter of the glass fibers is generally in the range of 5 micron to 200 micron. In contract, the glass wafer 102 may be a layer of glass that is about 10 millimeters on a side to about 250 millimeters on a side (e.g., 10 millimeters x 10 millimeters to 250 millimeters x 250 millimeters). In some embodiments, a cross-section of the glass wafer 102 in a side view or in a top-down view may be substantially rectangular, although in some further embodiments the glass wafer 102 may have rounded or beveled edges/sides/sidewalls. In some embodiments, in the top-down view of the glass wafer 102, the glass wafer 102 may have a first length in a range of 10 millimeters to 250 millimeters, and a second length in a range of 10 millimeters to 250 millimeters, the first length perpendicular to the second length. A thickness of the glass wafer 102 (e.g., a dimension measured along a vertical direction of the drawings of FIGS. 1A-1C) may be in a range of about 50 micron to 1.4 millimeters. In some embodiments, the glass wafer 102 may be a glass core substrate, where the glass core substrate has a thickness in a range of about 50 microns to 1.4 millimeters. In some embodiments, the glass wafer 102 may be a layer of glass comprising a rectangular prism volume, possibly with rounded or beveled edges/sides/sidewalls. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass wafer 102 may be a rectangular prism volume with sections (e.g., vias) removed and filled with other materials (e.g., metal). In some embodiments, the glass wafer 102 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

Although not specifically shown in order to not clutter the drawings, the glass wafer 102 may contain one or more optical components. Examples of such components include waveguide, lenses, attenuators, filters, polarizers, diffraction gratings, and microstructures such as micro-lenses or diffractive optical elements.

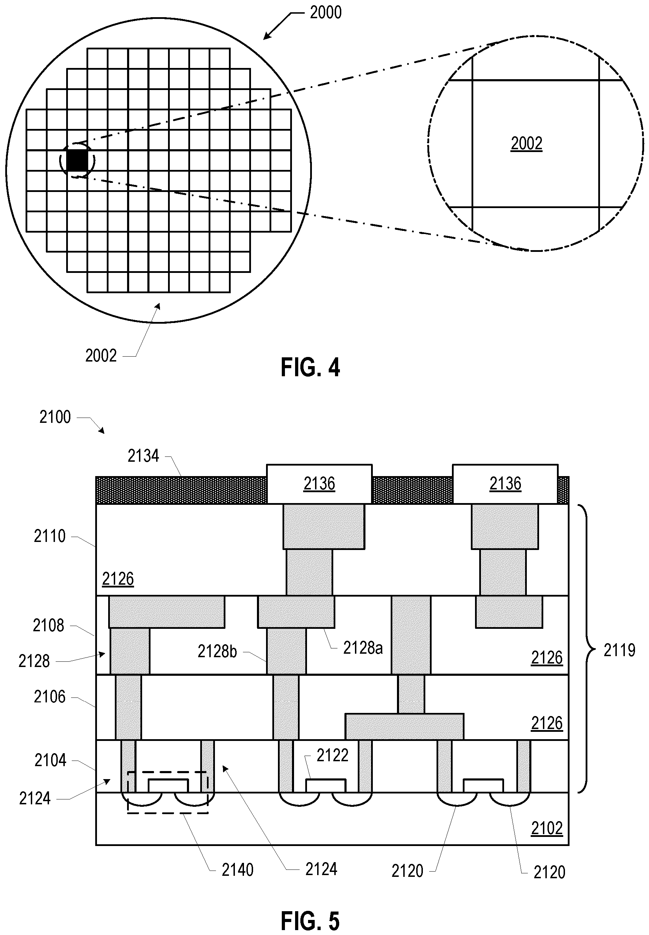

The semiconductor structure 104 may be any suitable semiconductor structure in which optical interconnects may be provided. For example, the semiconductor structure 104 may be a substrate, a die, a wafer, a chip, or any other suitable semiconductor structure. The semiconductor structure 104 may, e.g., be the wafer 2000 of FIG. 4, discussed below, and may be, or be included in, a die, e.g., the singulated die 2002 of FIG. 4, discussed below. In some embodiments, the semiconductor structure 104 may be a semiconductor substrate composed of semiconductor material systems including, for example, N-type or P-type materials systems. In one implementation, the semiconductor structure 104 may be a crystalline substrate formed using a bulk silicon or a silicon-on-insulator (SOI) substructure. In other implementations, the semiconductor structure 104 may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the semiconductor structure 104 may be non-crystalline. Although a few examples of materials from which the semiconductor structure 104 may be formed are described here, any material that may serve as a foundation in which optical interconnects as described herein may be built falls within the spirit and scope of the present disclosure.

The bonding interface 106 between the glass wafer 102 and the semiconductor structure 104 may include various materials. In some embodiments, an adhesive layer is applied between the glass wafer 102 and the semiconductor structure 104 to facilitate bonding. The adhesive material can be a polymer, such as photoresist or epoxy, or a bonding agent specifically designed for semiconductor applications. The adhesive layer may help to ensure strong adhesion between the glass wafer 102 and the semiconductor structure 104. In some embodiments, the bonding interface 106 may include an oxide of the one or more semiconductor materials of the semiconductor structure 104. For example, silicon wafers often have a native oxide layer (SiO2) on their surfaces due to exposure to oxygen in the atmosphere. This oxide layer may remain intact or may be intentionally grown or deposited as part of the bonding process. Silicon oxide can provide a chemically stable interface and promote bonding between the glass wafer 102 and the semiconductor structure 104. In some embodiments, the bonding interface 106 may include silicon and nitrogen, e.g., in the form of silicon nitride, because it may provide excellent adhesion and compatibility with both the glass wafer 102 and the semiconductor structure 104. Silicon nitride can be deposited onto the surface of the semiconductor structure 104 using techniques such as chemical vapor deposition (CVD) or plasma-enhanced chemical vapor deposition (PECVD). In certain bonding methods, a thin metal layer may be deposited on one or both of the bonding surfaces to enhance adhesion and promote bonding between the glass wafer 102 and the semiconductor structure 104. In some such embodiments, the bonding interface 106 may include one or more of titanium (Ti), chromium (Cr), nickel (Ni), or other metals. The metal layer can form chemical bonds with both the glass wafer 102 and the semiconductor structure 104, improving the strength and stability of the bond interface. In some embodiments, prior to bonding, the surface of the semiconductor structure 104 may undergo surface treatment processes such as cleaning, activation, or functionalization to enhance bonding properties and ensure compatibility with the glass wafer 102. In such embodiments, the bonding interface 106 may include features indicative of such surface treatment, e.g., chemical residues (e.g., residues from cleaning agents or surface activation chemicals may include traces of organic solvents or surfactants) and/or functional groups (e.g., silane molecules or other chemical species that facilitate bonding between the semiconductor and glass surfaces).

As shown in FIG. 1B, manufacturing of the microelectronic assembly 100 may then proceed with forming one or more openings 108 through the semiconductor structure 104. The openings 108 may extend from a face of the semiconductor structure 104 that is farthest away from the glass wafer 102, extend all the way to the opposite face of the semiconductor structure 104, and further extend through the bonding interface 106 to expose the glass wafer 102 at the bottom of the openings 108. Thus, the openings 108 may be through-semiconductor vias (TSVs). In some embodiments, a width of any of the openings 108 may be between about 50 nanometers and about 100 microns.

As shown in FIG. 1C, manufacturing of the microelectronic assembly 100 may then proceed with filling the one or more openings 108 with a glass material 110. In some embodiments, providing the glass material 110 within the openings 108 may include filling the openings 108 with molten glass. In this process, the glass material 110 may, first, be heated to a temperature above its glass transition temperature. As the glass softens and becomes viscous, it may flow into the openings 108. This process may be carried out in a controlled atmosphere to prevent oxidation of the semiconductor structure 104 or other undesirable reactions. After that, the glass material 110 in the openings 108 may be cooled and solidified. In some embodiments, the cooling rate may be carefully controlled to minimize stress and prevent cracking or warping. The glass material 110 may include any of the materials described above with reference to the glass wafer 102.

Because providing the glass material 110 within the openings 108 using molten glass is a high-temperature process, an interface layer 112 may form at an interface between the glass material 110 and a portion of the glass wafer 102 at the bottom of any of the openings 108. The interface layer 112 may be a layer in which there is a discontinuity between the glass wafer 102 and the glass material 110, e.g., in terms of grain alignment and/or grain size. In some embodiments, a grain size of the glass material 110 may be different, e.g., at least about 5% different or at least about 10% different, from a grain size of the glass wafer 102. In some embodiments, a grain alignment/orientation of the glass material 110 may be different, e.g., at least about 5% different or at least about 10% different, from a grain alignment/orientation of the glass wafer 102. The interface layer 112 may then be in between the properties (e.g., grain size and/or grain alignment/orientation) of the glass wafer 102 and the glass material 110. In some embodiments, a thickness of the interface layer 112 may be below about 10% of the height of the openings 108.

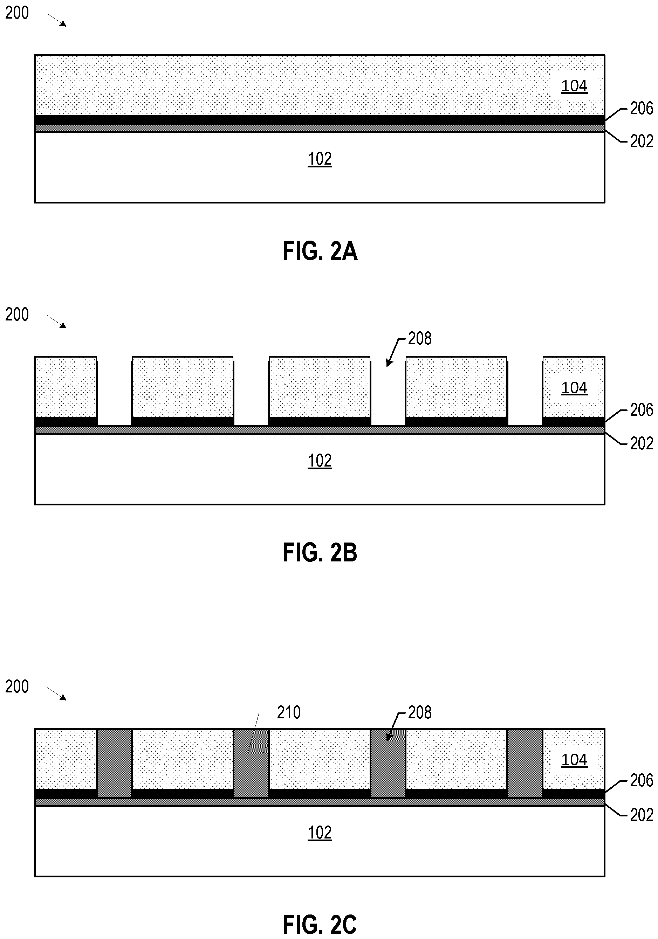

The glass material 110 within the openings 108 may provide effective optical interconnects between the glass wafer 102 and optical/photonic components implemented on the top surface of the semiconductor structure 104. An alternative material for providing such optical interconnects may be sapphire, as described with reference to FIGS. 2A-2C.

FIGS. 2A-2C illustrate cross-sectional side views during manufacturing of a microelectronic assembly 200 that includes a glass wafer integrated with a semiconductor structure with optical interconnects, in accordance with other embodiments.

As shown in FIG. 2A, manufacturing of a microelectronic assembly 200 may begin with bonding a glass wafer 102 with a semiconductor structure 104. The glass wafer 102 and the semiconductor structure 104 may be as described for the microelectronic assembly 100, except that, during manufacturing of the microelectronic assembly 200, prior to bonding, a seed layer 202 may be provided over the glass wafer 102. A bonding interface 206 may then form between the seed layer 202 and the semiconductor structure 104.

The seed layer 202 may include a thin layer of any suitable substantially crystalline material that may serve as a seed for epitaxially growing other materials in the TSVs in the semiconductor structure 104. The seed layer 202 may be deposited using a deposition technique such as physical vapor deposition (PVD) or CVD. PVD techniques that may be used for the deposition of the seed layer 202 include electron beam evaporation, sputtering, and pulsed laser deposition (PLD). Using CVD to provide the seed layer 202 may allow for precise control over film thickness and composition. In some embodiments, the seed layer 202 may have a thickness between about 50 nanometers and about 500 nanometers, or between about 1 micron and about 10 microns. In some embodiments, the seed layer 202 may be provided as a continuous layer over the glass wafer 102. In other embodiments, the seed layer 202 may be patterned to be present in some areas but not the others of the surface of the glass wafer 102. For example, the seed layer 202 may be present over the waveguides implemented within the glass wafer 102 but be absent in surfaces of the glass wafer 102 that are not substantially above the waveguides.

In some embodiments, the seed layer 202 may include a thin layer of a material comprising aluminum and oxygen (e.g., in the form of aluminum oxide, also known as "sapphire"). In such embodiments, when a PVD process is used to deposit the seed layer 202, a source material containing aluminum oxide (e.g., Al₂O₃), the primary component of sapphire, may be heated in a vacuum chamber to produce a vapor. The vaporized Al₂O₃ molecules condense onto the surface of the glass wafer 102, forming a thin seed layer 202 of sapphire. When a CVD process is used to deposit a thin seed layer 202 of sapphire, a precursor gas containing aluminum and oxygen may be introduced into a reaction chamber with the glass wafer 102 therein, possibly at elevated temperatures. The precursor gas may decompose on the surface of the glass wafer 102, and the aluminum and oxygen atoms react to form a sapphire thin film of the seed layer 202. In other embodiments, the seed layer 202 may include a thin layer of a material comprising aluminum and nitrogen (e.g., in the form of aluminum nitride). Such a seed layer 202 may also be deposited using PVD or CVD as described for aluminum oxide but using nitrogen instead of oxygen.

As a result of the bonding, a bonding interface 206 may be present between the seed layer 202 on the surface of the glass wafer 102 and the semiconductor structure 104. Descriptions provided for the bonding interface 106 are applicable to the bonding interface 206 except that they are for the bonding between the semiconductor structure 104 and the seed layer 202 and, in the interest of brevity, are not repeated.

As shown in FIG. 2B, manufacturing of the microelectronic assembly 200 may then proceed with forming one or more openings 208 through the semiconductor structure 104. The openings 208 may extend from a face of the semiconductor structure 104 that is farthest away from the glass wafer 102, extend all the way to the opposite face of the semiconductor structure 104, further extend through the bonding interface 206 to expose a portion of the seed layer 202 at the bottom of the openings 208. Thus, the openings 208 may be TSVs. In some embodiments, a width of any of the openings 208 may be between about 50 nanometers and about 100 microns.

As shown in FIG. 2C, manufacturing of the microelectronic assembly 200 may then proceed with filling the one or more openings 208 with an aluminum-based material 210. In some embodiments, providing the aluminum-based material 210 within the openings 208 may include epitaxially growing an aluminum-based material 210 within the openings 208, starting from the seed layer 202 at the bottoms of the openings 208. In such embodiments, the aluminum-based material 210 may include crystalline (e.g., substantially single-crystal) material comprising aluminum and oxygen and/or nitrogen. In some embodiments, the aluminum-based material 210 may include a material having a hexagonal crystal structure. In other embodiments, providing the aluminum-based material 210 within the openings 208 may include depositing an aluminum-based material 210 within the openings 208, starting from the seed layer 202 at the bottoms of the openings 208, using a suitable texture alignment technique. Epitaxial growth and texture alignment are two different methods used to control the orientation and alignment of crystalline structures in materials. When epitaxial growth is used, the aluminum-based material 210 may be a substantially single-crystalline material, with no or few grain boundaries, and the grain size of the grains of the aluminum-based material 210 being on the order of tens of nanometers. When texture alignment is used, the aluminum-based material 210 may be a material where the crystal grains or domains are oriented in a preferred direction or axis, resulting in an anisotropic material with directional properties, and the aluminum-based material 210 may include a polycrystalline material with an alignment of crystallographic orientations within it being affected by the seed layer 202.

In the embodiments where the seed layer 202 includes a material comprising aluminum and oxygen (e.g., sapphire), then the aluminum-based material 210 may also be a material comprising aluminum and oxygen (e.g., sapphire). In the embodiments where the seed layer 202 includes a material comprising aluminum and nitrogen (e.g., aluminum nitride), then the aluminum-based material 210 may also be a material comprising aluminum and nitrogen (e.g., aluminum nitride). Similar to sapphire, aluminum nitride may also have a hexagonal crystal structure, but it may have different properties than sapphire. Providing aluminum nitride within the openings 208, as opposed to sapphire, may offer advantages in terms of high thermal conductivity, electrical insulation (e.g., higher dielectric constant values), or compatibility with semiconductors. Providing sapphire within the openings 208, as opposed to aluminum nitride, may offer advantages in terms of optical transparency, hardness and scratch resistance, and chemical interness.

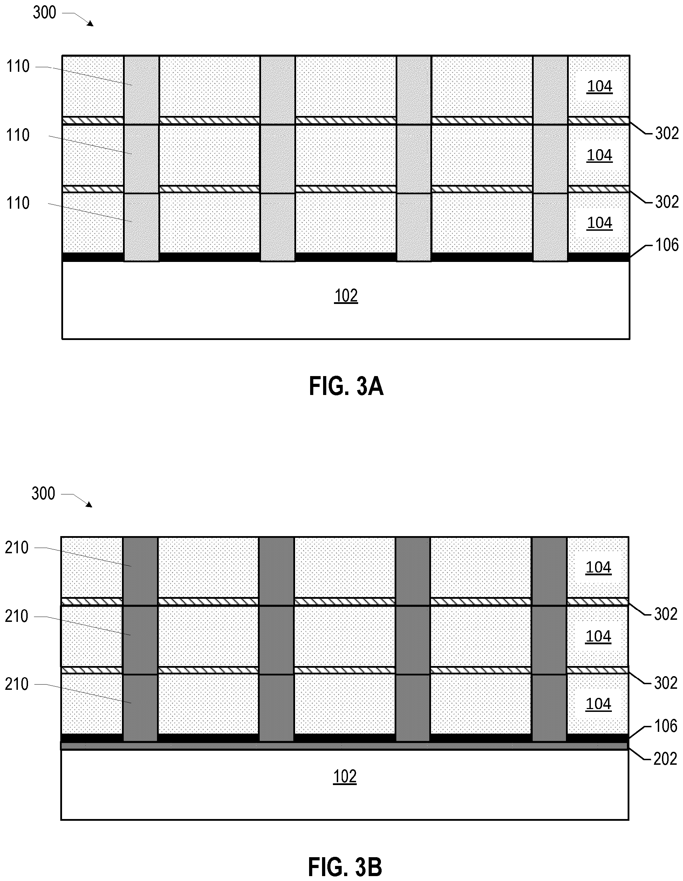

FIGS. 3A-3D illustrate cross-sectional side views of microelectronic assemblies that include a glass wafer integrated with stacks of semiconductor structures with optical interconnects, in accordance with various embodiments.

FIG. 3A illustrates a microelectronic assembly 300 in which a plurality of semiconductor structures 104 with TSVs filled with the glass material 110 are stacked above one another and above the glass wafer 102. As shown in FIG. 3A, a bonding interface 302 may be present between a pair of adjacent semiconductor structures 104. In some embodiments, adjacent semiconductor structures 104 may be bonded to one another using fusion bonding, which may involve bonding the two semiconductor structures 104 using pressure and heat, without the use of adhesives or additional materials. In such embodiments, the bonding interface 302 may be a fusion bonding interface, comprising silicon, nitrogen, and carbon. In other embodiments, an adhesive material may be used to bond the two semiconductor structures 104, in which case the bonding interface 302 may include traces of the adhesives, e.g., polymer materials. In some embodiments, multiple semiconductor structures 104 may be stacked above one another and above the glass wafer 102 first, then openings may be formed extending through the stack to the glass wafer 102, and then molten glass may be deposited into the openings to fill the TSVs in multiple semiconductor structures 104 at once. In other embodiments, TSVs in individual semiconductor structures 104 may be filled with the glass material 110 first and then such semiconductor structures 104 with TSVs filled with the glass material 110 may be bonded together. In still other embodiments, a combination of these two approaches may be implemented to provide a stack of semiconductor structures 104 with TSVs filled with the glass material 110 above the glass wafer 102.

FIG. 3B illustrates a microelectronic assembly 300 in which a plurality of semiconductor structures 104 with TSVs filled with the aluminum-based material 210 are stacked above one another and above the glass wafer 102. As shown in FIG. 3B, a bonding interface 302 may be present between a pair of adjacent semiconductor structures 104, and may be any of the bonding interfaces 302 described with reference to FIG. 3A. Because the aluminum-based material 210 is deposited into TSVs by epitaxial growth starting from the seed layer 202 as the seed layer, multiple semiconductor structures 104 may be stacked above one another and above the glass wafer 102 with the seed layer 202 on the top surface first, then openings may be formed extending through the stack to the seed layer 202, and then epitaxial deposition process may take place to grow the aluminum-based material 210 in the TSVs in multiple semiconductor structures 104 at once.

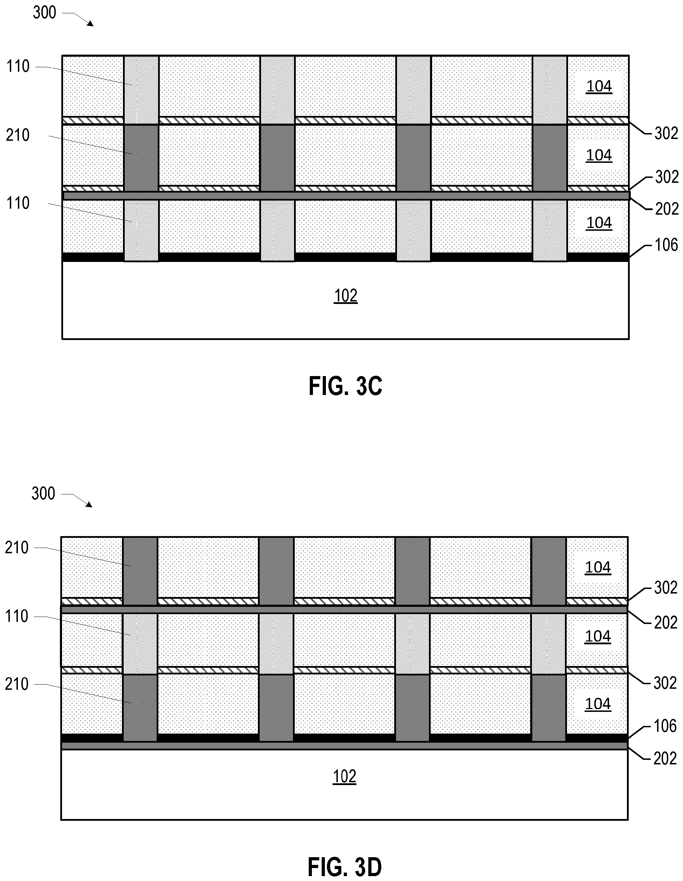

FIG. 3C and FIG. 3D illustrate microelectronic assemblies 300 in which a plurality of semiconductor structures 104 are stacked above one another and above the glass wafer 102, where one or more of the semiconductor structures 104 have TSVs filled with the glass material 110 and one or more of the semiconductor structures 104 have TSVs filled with the aluminum-based material 210. As shown in FIGS. 3C and 3D, in such embodiments, the seed layer 202 may be deposited over the upper surface before bonding the next semiconductor structure 104 if the previous semiconductor structure 104 did not have the aluminum-based material 210 in the TSVs, so that epitaxial growth starting from the seed layer 202 as the seed layer may be performed to fill the TSVs with the aluminum-based material 210. Otherwise, the bonding interface 302 as described above may be present between a pair of adjacent semiconductor structures 104.

The microelectronic assemblies having glass wafers integrated with semiconductor structures with optical interconnects disclosed herein (e.g., any of the microelectronic assemblies described with reference to FIGS. 1-3) may be included in any suitable electronic device. FIGS. 4-9 illustrate various examples of apparatuses that may be included in, or may include, one or more microelectronic assemblies having glass wafers integrated with semiconductor structures with optical interconnects disclosed herein.

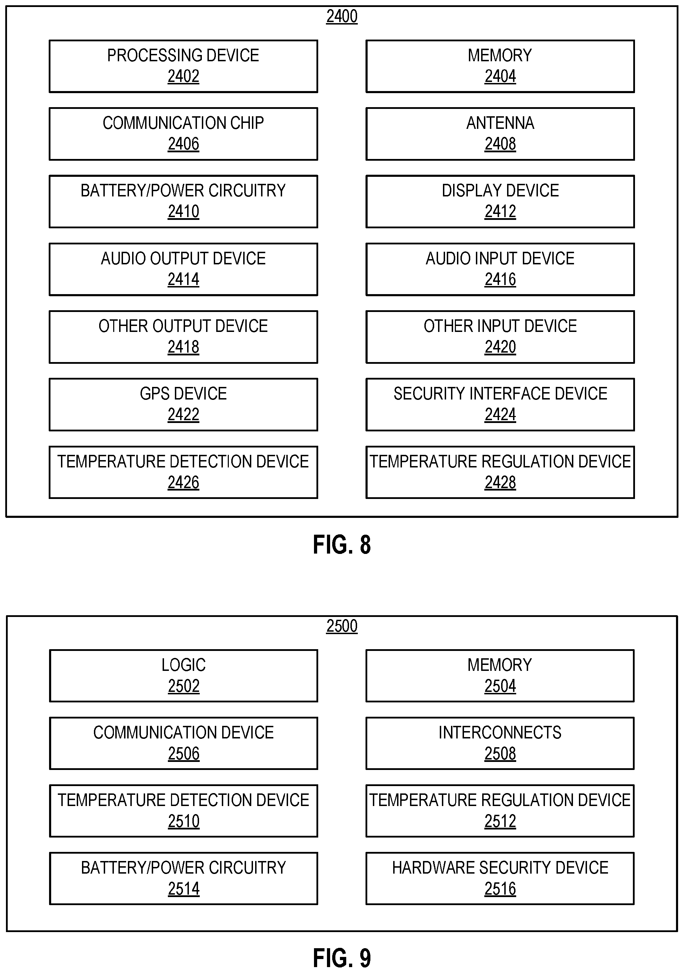

FIG. 4 illustrates top views of a wafer and dies that may be included in one or more microelectronic assemblies having glass wafers integrated with semiconductor structures with optical interconnects in accordance with any of the embodiments disclosed herein. The wafer 2000 may be composed of semiconductor material and may include one or more dies 2002 having IC structures formed on a surface of the wafer 2000. Each of the dies 2002 may be a repeating unit of a semiconductor product that includes any suitable IC structure. After the fabrication of the semiconductor product is complete (e.g., after manufacture of one or more IC structures), the wafer 2000 may undergo a singulation process in which each of the dies 2002 is separated from one another to provide discrete "chips" of the semiconductor product. In particular, microelectronic assemblies having glass wafers integrated with semiconductor structures with optical interconnects may include the semiconductor structures 104 in the form of the wafer 2000 (e.g., not singulated) or the form of the die 2002 (e.g., singulated). The die 2002 may include one or more transistors (e.g., some of the transistors 2140 of FIG. 5, discussed below), one or more memory cells, and/or supporting circuitry to route electrical signals to various IC components. In some embodiments, the wafer 2000 or the die 2002 may include a memory device, a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2500 of FIG. 9) or other logic that is configured to store information in the memory devices or execute instructions stored in the memory array.

FIG. 5 is a side, cross-sectional view of an IC device 2100 that may be included in microelectronic assemblies having glass wafers integrated with semiconductor structures with optical interconnects, in accordance with various embodiments. For example, the IC device 2100, or portions thereof, may be included in the semiconductor structures 104 of the microelectronic assemblies described with reference to FIGS. 1-3. In another example, one or more of the IC devices 2100 may be included in one or more dies 2002 of FIG. 4. The IC device 2100 may be formed on a substrate 2102 (e.g., the wafer 2000 of FIG. 4) and may be included in a die (e.g., the die 2002 of FIG. 4). The substrate 2102 may take on any forms of the substrates described above with reference to the semiconductor structure 104. In some embodiments, the substrate 2102 may be a PCB substrate.

The IC device 2100 may include one or more device layers 2104 disposed on the substrate 2102. The device layer 2104 may include features of one or more transistors 2140 (e.g., metal oxide semiconductor field-effect transistors (MOSFETs)) formed on the substrate 2102. The device layer 2104 may include, for example, one or more source and/or drain (S/D) regions 2120, a gate 2122 to control current flow in the transistors 2140 between the S/D regions 2120, and one or more S/D contacts 2124 to route electrical signals to/from the S/D regions 2120. The transistors 2140 may include additional features not depicted for the sake of clarity, such as device isolation regions, gate contacts, and the like. The transistors 2140 are not limited to the type and configuration depicted in FIG. 5 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 2140 may include a gate 2122 formed of at least two layers, a gate insulator and a gate electrode. The gate insulator may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate insulator include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate insulator to improve its quality when a high-k material is used.

The gate electrode may be formed on the gate insulator and may include at least one P-type work function metal or N-type work function metal, depending on whether the transistor 2140 is to be a P-type metal oxide semiconductor (PMOS) or an N-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 2140 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2120 may be formed within the substrate 2102 adjacent to the gate 2122 of each transistor 2140. The S/D regions 2120 may be formed using an implantation/diffusion process or an etching/deposition process, for example. In the former process, dopants such as boron, aluminum, antimony, phosphorous, or arsenic may be ion-implanted into the substrate 2102 to form the S/D regions 2120. An annealing process that activates the dopants and causes them to diffuse farther into the substrate 2102 may follow the ion-implantation process. In the latter process, the substrate 2102 may first be etched to form recesses at the locations of the S/D regions 2120. An epitaxial deposition process may then be carried out to fill the recesses with material that is used to fabricate the S/D regions 2120. In some implementations, the S/D regions 2120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2120 may be formed using one or more alternate semiconductor materials such as germanium or a group III-V material or alloy. In further embodiments, one or more layers of metal and/or metal alloys may be used to form the S/D regions 2120.

Electrical signals, such as power and/or input/output (I/O) signals, may be routed to and/or from the devices (e.g., the transistors 2140) of the device layer 2104 through one or more interconnect layers disposed on the device layer 2104 (illustrated in FIG. 5 as interconnect layers 2106, 2108, and 2110). For example, electrically conductive features of the device layer 2104 (e.g., the gate 2122 and the S/D contacts 2124) may be electrically coupled with the interconnect structures 2128 of the interconnect layers 2106, 2108, and 2110. The one or more interconnect layers 2106, 2108, and 2110 may form a metallization stack (also referred to as an "ILD stack") 2119 of the IC device 2100.

The interconnect structures 2128 may be arranged within the interconnect layers 2106, 2108, and 2110 to route electrical signals according to a wide variety of designs (in particular, the arrangement is not limited to the particular configuration of interconnect structures 2128 depicted in FIG. 5). Although a particular number of interconnect layers 2106, 2108, and 2110 is depicted in FIG. 5, embodiments of the present disclosure include IC devices having more or fewer interconnect layers than depicted.

In some embodiments, the interconnect structures 2128 may include lines 2128a and/or vias 2128b filled with an electrically conductive material such as a metal. The lines 2128a may be arranged to route electrical signals in a direction of a plane that is substantially parallel with a surface of the substrate 2102 upon which the device layer 2104 is formed. For example, the lines 2128a may route electrical signals in a direction in and out of the page from the perspective of FIG. 5. The vias 2128b may be arranged to route electrical signals in a direction of a plane that is substantially perpendicular to the surface of the substrate 2102 upon which the device layer 2104 is formed. In some embodiments, the vias 2128b may electrically couple lines 2128a of different interconnect layers 2106, 2108, and 2110 together.

The interconnect layers 2106, 2108, and 2110 may include an insulator material 2126 disposed between the interconnect structures 2128, as shown in FIG. 5. In some embodiments, the insulator material 2126 disposed between the interconnect structures 2128 in different ones of the interconnect layers 2106, 2108, and 2110 may have different compositions; in other embodiments, the composition of the insulator material2126 between different interconnect layers 2106, 2108, and 2110 may be the same.

A first interconnect layer 2106 may be formed above the device layer 2104. In some embodiments, the first interconnect layer 2106 may include lines 2128a and/or vias 2128b, as shown. The lines 2128a of the first interconnect layer 2106 may be coupled with contacts (e.g., the S/D contacts 2124) of the device layer 2104.

A second interconnect layer 2108 may be formed above the first interconnect layer 2106. In some embodiments, the second interconnect layer 2108 may include vias 2128b to couple the lines 2128a of the second interconnect layer 2108 with the lines 2128a of the first interconnect layer 2106. Although the lines 2128a and the vias 2128b are structurally delineated with a line within each interconnect layer (e.g., within the second interconnect layer 2108) for the sake of clarity, the lines 2128a and the vias 2128b may be structurally and/or materially contiguous (e.g., simultaneously filled during a dual-damascene process) in some embodiments.

A third interconnect layer 2110 (and additional interconnect layers, as desired) may be formed in succession on the second interconnect layer 2108 according to similar techniques and configurations described in connection with the second interconnect layer 2108 or the first interconnect layer 2106. In some embodiments, the interconnect layers that are "higher up" in the metallization stack 2119 in the IC device 2100 (i.e., farther away from the device layer 2104) may be thicker.

The IC device 2100 may include a solder resist material 2134 (e.g., polyimide or similar material) and one or more conductive contacts 2136 formed on the interconnect layers 2106, 2108, and 2110. In FIG. 5, the conductive contacts 2136 are illustrated as taking the form of bond pads. The conductive contacts 2136 may be electrically coupled with the interconnect structures 2128 and configured to route the electrical signals of the transistor(s) 2140 to other external devices. For example, solder bonds may be formed on the one or more conductive contacts 2136 to mechanically and/or electrically couple a chip including the IC device 2100 with another component (e.g., a circuit board). The IC device 2100 may include additional or alternate structures to route the electrical signals from the interconnect layers 2106, 2108, and 2110; for example, the conductive contacts 2136 may include other analogous features (e.g., posts) that route the electrical signals to external components.

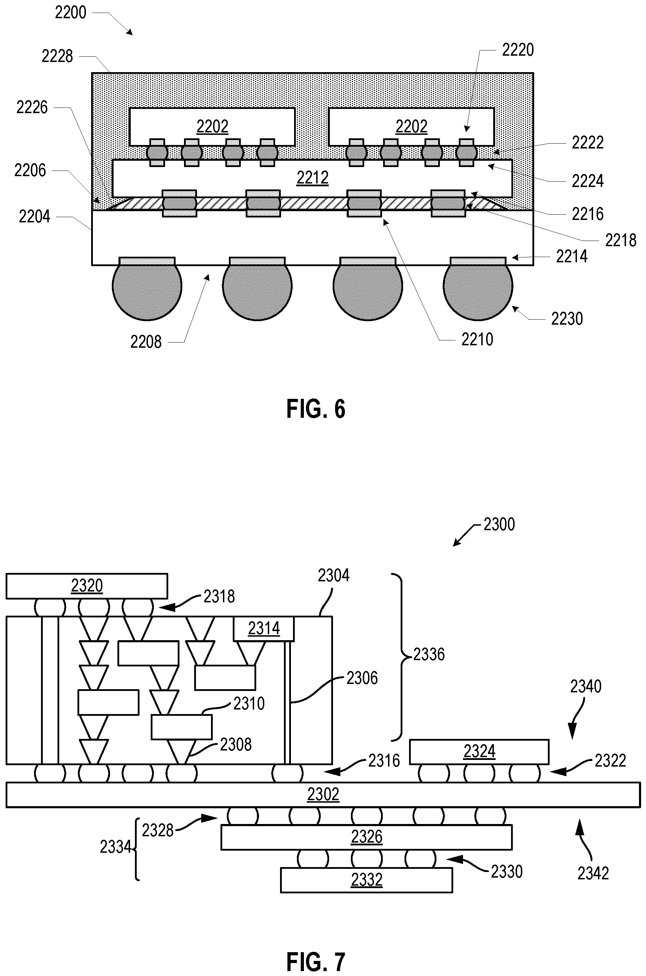

FIG. 6 is a side, cross-sectional view of an example IC package 2200 that may include one or more microelectronic assemblies having glass wafers integrated with semiconductor structures with optical interconnects, in accordance with various embodiments. For example, in some embodiments, the dies 2202 may be semiconductor structures 104 with TSVs with the glass material 110 and/or the aluminum-based material 210 and be bonded with the glass wafers 102 as described herein. In another example, in some embodiments, any of the dies 2202 of the IC package 2200 may be implemented as the die 2002 of FIG. 4. In some embodiments, the dies 2202 may include any of the embodiments of the IC device 2100. In embodiments in which the IC package 2200 includes multiple dies 2202, the IC package 2200 may be referred to as a multi-chip package (MCP). The dies 2202 may include circuitry to perform any desired functionality. For example, or more of the dies 2202 may be logic dies (e.g., silicon-based dies), and one or more of the dies 2202 may be memory dies (e.g., high bandwidth memory). In some embodiments, the IC package 2200 may be a system-in-package (SiP). In some embodiments, the IC package 2200 may include a photonics IC (PIC) co-packaged with an IC package. In some embodiments, the IC package 2200 may include fully integrated electronic photonics ICs (EPICs).

The IC package 2200 may include a package substrate 2204 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 2206 and the face 2208, or between different locations on the face 2206, and/or between different locations on the face 2208. These conductive pathways may take the form of any of the interconnect structures 2128 discussed above with reference to FIG. 5.

The package substrate 2204 may include conductive contacts 2210 that are coupled to conductive pathways (not shown) through the package substrate 2204, allowing circuitry within the dies 2202 and/or the interposer 2212 to electrically couple to various ones of the conductive contacts 2214 (or to other devices included in the package substrate 2204, not shown). The IC package 2200 may include an interposer 2212 coupled to the package substrate 2204 via conductive contacts 2216 of the interposer 2212, first-level interconnects 2218, and the conductive contacts 2210 of the package substrate 2204. The first-level interconnects 2218 illustrated in FIG. 6 are solder bumps, but any suitable first-level interconnects 2218 may be used. In some embodiments, no interposer 2212 may be included in the IC package 2200; instead, the dies 2202 may be coupled directly to the conductive contacts 2210 at the face 2206 by first-level interconnects 2218. More generally, one or more dies 2202 may be coupled to the package substrate 2204 via any suitable structure (e.g., a silicon bridge, an organic bridge, one or more waveguides, one or more interposers, wirebonds, etc.).

The IC package 2200 may include one or more dies 2202 coupled to the interposer 2212 via conductive contacts 2220 of the dies 2202, first-level interconnects 2222, and conductive contacts 2224 of the interposer 2212. The conductive contacts 2224 may be coupled to conductive pathways (not shown) through the interposer 2212, allowing circuitry within the dies 2202 to electrically couple to various ones of the conductive contacts 2216 (or to other devices included in the interposer 2212, not shown). The first-level interconnects 2222 illustrated in FIG. 6 are solder bumps, but any suitable first-level interconnects 2222 may be used. For example, the first-level interconnects 2222 may include hybrid bonding interconnects. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 2226 may be disposed between the package substrate 2204 and the interposer 2212 around the first-level interconnects 2218, and a mold compound 2228 may be disposed around the dies 2202 and the interposer 2212 and in contact with the package substrate 2204. In some embodiments, the underfill material 2226 may be the same as the mold compound 2228. Example materials that may be used for the underfill material 2226 and the mold compound 2228 are epoxy mold materials, as suitable. Second-level interconnects 2230 may be coupled to the conductive contacts 2214. The second-level interconnects 2230 illustrated in FIG. 6 are solder balls (e.g., for a ball grid array arrangement), but any suitable second-level interconnects 2230 may be used (e.g., pins in a pin grid array arrangement or lands in a land grid array arrangement). The second-level interconnects 2230 may be used to couple the IC package 2200 to another component, such as a circuit board (e.g., a motherboard), an interposer, or another IC package, as known in the art and as discussed below with reference to FIG. 7.

Although the IC package 2200 illustrated in FIG. 6 is a flip chip package, other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fanout (FO) package. Although two dies 2202 are illustrated in the IC package 2200 of FIG. 6, an IC package 2200 may include any desired number of dies 2202. An IC package 2200 may include additional passive components, such as surface-mount resistors, capacitors, and inductors disposed on the first face 2206 or the second face 2208 of the package substrate 2204, or on either face of the interposer 2212. More generally, an IC package 2200 may include any other active or passive components known in the art.

FIG. 7 is a side, cross-sectional view of an IC device assembly 2300 that may include one or more microelectronic assemblies having glass wafers integrated with semiconductor structures with optical interconnects in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. Any of the IC packages discussed below with reference to the IC device assembly 2300 may take the form of any of the embodiments of the IC package 2200 discussed above with reference to FIG. 6.

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 7 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (as shown in FIG. 7), male and female portions of a socket, an adhesive, an underfill material, and/or any other suitable electrical and/or mechanical coupling structure.

The package-on-interposer structure 2336 may include an IC package 2320 coupled to an package interposer 2304 by coupling components 2318. The coupling components 2318 may take any suitable form for the application, such as the forms discussed above with reference to the coupling components 2316. Although a single IC package 2320 is shown in FIG. 7, multiple IC packages may be coupled to the package interposer 2304; indeed, additional interposers may be coupled to the package interposer 2304. The package interposer 2304 may provide an intervening substrate used to bridge the circuit board 2302 and the IC package 2320. The IC package 2320 may be or include, for example, a die (the die 2002 of FIG. 4), an IC device (e.g., the IC device 2100 of FIG. 5), or any other suitable component. Generally, the package interposer 2304 may spread a connection to a wider pitch or reroute a connection to a different connection. For example, the package interposer 2304 may couple the IC package 2320 (e.g., a die) to a set of BGA conductive contacts of the coupling components 2316 for coupling to the circuit board 2302. In the embodiment illustrated in FIG. 7, the IC package 2320 and the circuit board 2302 are attached to opposing sides of the package interposer 2304; in other embodiments, the IC package 2320 and the circuit board 2302 may be attached to a same side of the package interposer 2304. In some embodiments, three or more components may be interconnected by way of the package interposer 2304.

In some embodiments, the package interposer 2304 may be formed as a PCB, including multiple metal layers separated from one another by layers of dielectric material and interconnected by electrically conductive vias. In some embodiments, the package interposer 2304 may be formed of an epoxy resin, a fiberglass-reinforced epoxy resin, an epoxy resin with inorganic fillers, a ceramic material, or a polymer material such as polyimide. In some embodiments, the package interposer 2304 may be formed of alternate rigid or flexible materials that may include the same materials described above for use in a semiconductor substrate, such as silicon, germanium, and other group III-V and group IV materials. The package interposer 2304 may include metal lines 2310 and vias 2308, including but not limited to TSVs 2306. The package interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 7 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 8 is a block diagram of an example computing device 2400 that may include one or more components including one or more microelectronic assemblies having glass wafers integrated with semiconductor structures with optical interconnects in accordance with any of the embodiments disclosed herein. For example, any suitable ones of the components of the computing device 2400 may include any of the microelectronic assemblies having glass wafers integrated with semiconductor structures with optical interconnects as described herein. Any one or more of the components of the computing device 2400 may include an IC device 2100 of FIG. 5, an IC package 2200 of FIG. 6, or an IC device assembly 2300 of FIG. 7.

A number of components are illustrated in FIG. 8 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 8, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414, but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), non-volatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque MRAM.

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

FIG. 9 is a block diagram of an example processing device 2500 that may include one or more components including one or more microelectronic assemblies having glass wafers integrated with semiconductor structures with optical interconnects as described herein. For example, any suitable ones of the components of the processing device 2500 may include any of the microelectronic assemblies having glass wafers integrated with semiconductor structures with optical interconnects as described herein. Any one or more of the components of the processing device 2500 may include an IC device 2100 of FIG. 5, an IC package 2200 of FIG. 6, or an IC device assembly 2300 of FIG. 7. Any one or more of the components of the processing device 2500 may include, or be included in, a computing device 2400 of FIG. 8; for example, the processing device 2500 may be the processing device 2402 of the computing device 2400.

A number of components are illustrated in FIG. 9 as included in the processing device 2500, but any one or more of these components may be omitted or duplicated, as suitable for the application. In some embodiments, some or all of the components included in the processing device 2500 may be attached to one or more motherboards. In some embodiments, some or all of these components are fabricated on a single SoC die or coupled to a single support structure, e.g., to a single carrier substrate.

Additionally, in various embodiments, the processing device 2500 may not include one or more of the components illustrated in FIG. 9, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more of input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 2404 (FIG. 8). In some embodiments, the memory 2504 may be a designated device configured to provide storage functionality for the components of the processing device 2500 (e.g., local), while the memory 2404 may be configured to provide system-level storage functionality for the entire computing device 2400 (e.g., global). In some embodiments, the memory 2504 may include memory that shares a die with the logic circuitry 2502.

The processing device 2500 may include a communication device 2506, which may be implemented substantially as described above with reference to the communication chip 2406 (FIG. 8). In some embodiments, the communication device 2506 may be a designated device configured to provide communication functionality for the components of the processing device 2500 (e.g., local), while the communication chip 2406 may be configured to provide system-level communication functionality for the entire computing device 2400 (e.g., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"). In some embodiments, the interconnects 2508 may be implemented as the interconnect structures 2128 of FIG. 5, described above.

The processing device 2500 may include a temperature detection device 2510 which may be implemented substantially as described above with reference to the temperature detection device 2426 of FIG. 8 but configured to determine temperatures on a more local scale, e.g., of the processing device 2500 of components thereof. In some embodiments, the temperature detection device 2510 may be a designated device configured to provide temperature detection functionality for the components of the processing device 2500 (e.g., local), while the temperature detection device 2426 may be configured to provide system-level temperature detection functionality for the entire computing device 2400 (e.g., global).

The processing device 2500 may include a temperature regulation device 2512 which may be implemented substantially as described above with reference to the temperature regulation device 2428 of FIG. 8 but configured to regulate temperatures on a more local scale, e.g., of the processing device 2500 of components thereof. In some embodiments, the temperature regulation device 2512 may be a designated device configured to provide temperature regulation functionality for the components of the processing device 2500 (e.g., local), while the temperature regulation device 2428 may be configured to provide system-level temperature regulation functionality for the entire computing device 2400 (e.g., global).

The processing device 2500 may include a battery/power circuitry 2514 which may be implemented substantially as described above with reference to the battery/power circuitry 2410 of FIG. 8. In some embodiments, the battery/power circuitry 2514 may be a designated device configured to provide battery/power functionality for the components of the processing device 2500 (e.g., local), while the battery/power circuitry 2410 may be configured to provide system-level battery/power functionality for the entire computing device 2400 (e.g., global).

The processing device 2500 may include a hardware security device 2516 which may be implemented substantially as described above with reference to the security interface device 2424 of FIG. 8. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure cryptoprocessors chips.

Example 1 provides a microelectronic assembly that includes a glass structure having a first face and a second face opposite the first face; and a semiconductor structure having a first face and a second face opposite the first face, where: the first face of the glass structure is further away from the semiconductor structure than the second face of the glass structure, the second face of the glass structure is bonded with the first face of the semiconductor structure, the semiconductor structure includes an opening extending between the first face of the semiconductor structure and the second face of the semiconductor structure, and the microelectronic assembly further includes an optical interconnect in the opening.

Example 2 provides the microelectronic assembly according to example 1, where the optical interconnect includes glass.

Example 3 provides the microelectronic assembly according to example 2, further including an interface layer between the glass of the optical interconnect and the glass structure.

Example 4 provides the microelectronic assembly according to example 3, where the interface layer includes a grain property (e.g., a grain size or a grain orientation) that is between a grain property of the glass structure and a glass property of the glass of the optical interconnect.

Example 5 provides the microelectronic assembly according to any one of examples 2-4, further where a grain size of the glass of the optical interconnect is different from a grain size of the glass structure.

Example 6 provides the microelectronic assembly according to any one of examples 2-5, further where a grain alignment of the glass of the optical interconnect is different from a grain alignment of the glass structure.

Example 7 provides the microelectronic assembly according to example 1, where the optical interconnect includes a material including aluminum and oxygen.

Example 8 provides the microelectronic assembly according to example 7, where the material including aluminum and oxygen is substantially single-crystalline.

Example 9 provides the microelectronic assembly according to any one of examples 1, 7, or 8, where the optical interconnect includes sapphire.

Example 10 provides the microelectronic assembly according to any one of examples 7-9, further including an interface layer between the optical interconnect and the glass structure, where the interface layer includes aluminum and oxygen.

Example 11 provides the microelectronic assembly according to example 10, where: the interface layer is a first interface layer, and the microelectronic assembly further includes a second interface layer between the optical interconnect and the glass structure.

Example 12 provides the microelectronic assembly according to example 11, where the second interface layer is absent between the optical interconnect and the glass structure.

Example 13 provides the microelectronic assembly according to example 1, where the optical interconnect includes a material including aluminum and nitrogen.

Example 14 provides the microelectronic assembly according to example 13, further including an interface layer between the optical interconnect and the glass structure, where the interface layer includes aluminum and nitrogen.

Example 15 provides the microelectronic assembly according to example 14, where: the interface layer is a first interface layer, the microelectronic assembly further includes a second interface layer between the optical interconnect and the glass structure, and the second interface layer is absent between the optical interconnect and the glass structure.

Example 16 provides the microelectronic assembly according to any one of examples 1 or 7-15 or claims 7-15, where the optical interconnect includes a material having a hexagonal crystal structure.

Example 17 provides a microelectronic assembly that includes a glass wafer; and a semiconductor structure attached to the glass wafer (e.g., a semiconductor die or a semiconductor wafer), where: the semiconductor structure includes an opening extending between a first face and a second face of the semiconductor structure, the first face is a face of the semiconductor structure bonded to a face of the glass wafer, the second face is a face of the semiconductor structure opposite the first face, and the opening includes a material that either includes aluminum and oxygen or includes aluminum and nitrogen.

Example 18 provides the microelectronic assembly according to example 17, further including a first interface layer between the material in the opening and the glass wafer, and a second interface layer between the semiconductor structure and the glass wafer, where: the first interface layer includes aluminum, the second interface layer includes a semiconductor material of the semiconductor structure and one or more of oxygen, nitrogen, or carbon, and the second interface layer is absent between the material in the opening and the glass wafer.

Example 19 provides a microelectronic assembly that includes a glass wafer; and a semiconductor structure attached to the glass wafer (e.g., a semiconductor die or a semiconductor wafer), where: the semiconductor structure includes an opening extending between a first face and a second face of the semiconductor structure, the first face is a face of the semiconductor structure bonded to a face of the glass wafer, the second face is a face of the semiconductor structure opposite the first face, and the opening includes a material having a hexagonal crystal structure.

Example 20 provides the microelectronic assembly according to example 19, further including a first interface layer between the material in the opening and the glass wafer, and a second interface layer between the semiconductor structure and the glass wafer, where: the first interface layer includes aluminum, the second interface layer includes a semiconductor material of the semiconductor structure and one or more of oxygen, nitrogen, or carbon, and the second interface layer is absent between the material in the opening and the glass wafer.

Example 21 provides an IC package, including a microelectronic assembly according to any one of the preceding examples; and a further component, coupled to the microelectronic assembly.

Example 22 provides the IC package according to example 21, where the further component is one of a package substrate, an interposer, or an IC die.

Example 23 provides the IC package according to examples 21 or 22, further including an insulator material around at least a portion of the microelectronic assembly.

Example 24 provides the IC package according to any one of examples 21-23, further including interconnects between the further component and the microelectronic assembly.

Example 25 provides the IC package according to example 24, where the interconnects are solder bumps.

Example 26 provides the IC package according to example 24, where the interconnects are hybrid bonding interconnects.

Example 27 provides the IC package according to any one of examples 24-26, further including first conductive contacts at a surface of the further component closest to the microelectronic assembly; and second conductive contacts at a surface of the microelectronic assembly closest to the further component, where the interconnects are between the first conductive contacts and the second conductive contacts.

Example 28 provides the IC package according to example 27, where at least one of the first conductive contacts or the second conductive contacts includes a conductive pad.

Example 29 provides the IC package according to example 27, where at least one of the first conductive contacts or the second conductive contacts includes a conductive socket.

Example 30 provides the IC package according to any one of examples 21-29, where: the further component is an interposer, the IC package further includes a package substrate coupled to the interposer, the microelectronic assembly is coupled to a first face of the interposer, and the package substrate is coupled to a second face of the interposer opposite the first face of the interposer.

Example 31 provides the IC package according to example 30, further including interconnects between the interposer and the package substrate.

Example 32 provides the IC package according to example 31, further including an underfill material around the interconnects.

Example 33 provides an electronic device, including a carrier substrate; and a microelectronic assembly according to any one of the preceding examples, coupled to the carrier substrate.

Example 34 provides the electronic device according to example 33, where the carrier substrate is a motherboard.

Example 35 provides the electronic device according to example 33, where the carrier substrate is a PCB.

Example 36 provides the electronic device according to any one of examples 33-35, where the electronic device is a wearable electronic device (e.g., a smart watch) or handheld electronic device (e.g., a mobile phone).

Example 37 provides the electronic device according to any one of examples 33-36, where the electronic device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a glass structure having a first face and a second face opposite the first face; and
a semiconductor structure having a first face and a second face opposite the first face, wherein:
the first face of the glass structure is further away from the semiconductor structure than the second face of the glass structure,
the second face of the glass structure is bonded with the first face of the semiconductor structure,
the semiconductor structure includes an opening extending between the first face of the semiconductor structure and the second face of the semiconductor structure, and
the microelectronic assembly further includes an optical interconnect in the opening.

2. The microelectronic assembly according to claim 1, wherein the optical interconnect includes glass.

3. The microelectronic assembly according to claim 2, further comprising an interface layer between the glass of the optical interconnect and the glass structure, wherein the interface layer includes a grain property that is between a grain property of the glass structure and a glass property of the glass of the optical interconnect.

4. The microelectronic assembly according to any one of claims 2-3, further wherein a grain size of the glass of the optical interconnect is different from a grain size of the glass structure.

5. The microelectronic assembly according to any one of claims 2-4, further wherein a grain alignment of the glass of the optical interconnect is different from a grain alignment of the glass structure.

6. The microelectronic assembly according to claim 1, wherein the optical interconnect includes a material comprising aluminum and oxygen.

7. The microelectronic assembly according to claim 6, wherein the material comprising aluminum and oxygen is substantially single-crystalline.

8. The microelectronic assembly according to any one of claims 1, 6, or 7, wherein the optical interconnect includes sapphire.

9. The microelectronic assembly according to claim 6, further comprising:
a first interface layer between the optical interconnect and the glass structure, wherein the first interface layer includes aluminum and oxygen; and
a second interface layer between the optical interconnect and the glass structure.

10. The microelectronic assembly according to claim 9, wherein the second interface layer is absent between the optical interconnect and the glass structure.

11. The microelectronic assembly according to any one of claims 1 or 6-10, wherein the optical interconnect includes a material having a hexagonal crystal structure.

12. A microelectronic assembly, comprising:
a glass wafer; and
a semiconductor structure attached to the glass wafer,
wherein:
the semiconductor structure includes an opening extending between a first face and a second face of the semiconductor structure,
the first face is a face of the semiconductor structure bonded to a face of the glass wafer,
the second face is a face of the semiconductor structure opposite the first face, and
the opening includes a material that either includes aluminum and oxygen or includes aluminum and nitrogen.

13. The microelectronic assembly according to claim 12, further comprising:
a first interface layer between the material in the opening and the glass wafer, and
a second interface layer between the semiconductor structure and the glass wafer, wherein:
the first interface layer includes aluminum,
the second interface layer includes a semiconductor material of the semiconductor structure and one or more of oxygen, nitrogen, or carbon, and
the second interface layer is absent between the material in the opening and the glass wafer.

14. A microelectronic assembly, comprising:
a glass wafer; and
a semiconductor structure attached to the glass wafer, wherein:
the semiconductor structure includes an opening extending between a first face and a second face of the semiconductor structure,
the first face is a face of the semiconductor structure bonded to a face of the glass wafer,
the second face is a face of the semiconductor structure opposite the first face, and
the opening includes a material having a hexagonal crystal structure.

15. The microelectronic assembly according to claim 14, further comprising:
a first interface layer between the material in the opening and the glass wafer, and
a second interface layer between the semiconductor structure and the glass wafer, wherein:
the first interface layer includes aluminum,
the second interface layer includes a semiconductor material of the semiconductor structure and one or more of oxygen, nitrogen, or carbon, and
the second interface layer is absent between the material in the opening and the glass wafer.
